# EUROPEAN PATENT APPLICATION

(11) **EP 4 715 396 A1**
(43) Date of publication of application: **25.03.2026**
(21) Application number: 24202329.9
(22) Date of filing: 24.09.2024
(51) Int. Cl.: G01R 11/04

(54) **ELECTRIC METER, COMBINATION OF ELECTRIC METER AND ELECTRIC METER MOUNTING PLATE, AND METHOD FOR MOUNTING ELECTRIC METER ONTO MOUNTING PLATE**

(71) Applicant: Aidon Oy, 40100 Jyväskylä (FI)
(72) Inventor: Sievänen, Aleksi, 40100 Jyväskylä (FI); Lohvansuu, Juha, 40720 Jyväskylä (FI)
(74) Representative: Berggren Oy

(57) **Abstract**

The invention relates to an electric meter (10), comprising an integrated position adjustment system (19) for adjusting a position of the electric meter (10) or at least a cable connector part (15) of the electric meter (10). The integrated position adjustment system (19) comprises a positioning mechanism (12) with a position setting and locking system (13) within the electric meter (10), and a mounting component (20) comprising a compatible matching part (22) to the position setting and locking system (13) of the positioning mechanism (12), and at least one mounting component opening (21). The mounting component (20) is arranged to be moved relative to the positioning mechanism (12) when adjusting the position.

## Description

### Technical field

The present invention generally relates to electric meters. Specifically, the invention relates to position adjustment of electric meters.

### Background

Electric meters are a known commodity in the field of electrical engineering. In general, the setting and mounting of electric meters is done with limited position adjustment possibility.

As electric cables may be repeatedly attached to and detached from the electric meter, for example, due to a renovation work or replacement of an electric meter with a new one, the cables may require cutting and subsequently may shorten during their lifespan. Over time, the shortening of the cables may lead to the problem of inability to reconnect the cables to the electric meter.

### Summary

An objective of the present invention is to provide an electric meter, a combination of the electric meter and an electric meter mounting plate, and a method for mounting the electric meter onto an electric meter mounting plate. Another objective of the present invention is to provide an electric meter that has vast position adjustment capabilities.

The objectives of this invention are reached by an electric meter, a combination of the electric meter and an electric meter mounting plate, and a method for mounting the electric meter onto an electric meter mounting plate as defined by the respective independent claims.

According to a first aspect, an electric meter is provided. The electric meter comprises an integrated position adjustment system for adjusting a position of the electric meter or at least a cable connector part of the electric meter. The integrated position adjustment system comprises a positioning mechanism with a position setting and locking system within the electric meter. The integrated position adjustment system further comprises a mounting component comprising a compatible matching part to the position setting and locking system of the positioning mechanism, and, preferably, at least one mounting component opening. The mounting component is arranged to be moved relative to the positioning mechanism when adjusting the position

The position setting and locking system may be adapted to provide both setting of the position and locking between the mounting component, optionally via the compatible matching part, and the positioning mechanism to a desired position of a plurality positions. The locking may be provided at least relative to a direction of the position adjustment. In addition, the locking may also be provided relative to another direction.

Moving the mounting component relative to the positioning mechanism when adjusting the position may require first unlocking the mounting component relative to the positioning mechanism and/or applying force to overcome locking, such as a mechanical interlocking, therebetween, and then moving the mounting component relative to the positioning mechanism. Subsequently, locking may be performed.

The positioning mechanism within the electric meter may be grooved. The groove or grooves of the positioning mechanism may be parallel to a direction of the position adjustment. Thus, the compatible matching part may be moved, such as slid, along the groove or grooves.

The position setting and locking system of the positioning mechanism within the electric meter may be stepped or stepless. In a stepped design of the position setting and locking system, the matching part may be set on a desired step or steps. The step or steps may also provide the locking, such as via mechanical interlocking, optionally via corresponding shapes. In a stepless design of the position setting and locking system, the matching part may be set on a desired position of the stepless position setting and locking system and the matching part can be fastened onto the position setting and locking system with an external fastening member. An external fastening member may also be used in a stepped design of the position setting and locking system.

The stepped position setting and locking system of the positioning mechanism within the electric meter may include a plurality of steps for setting the position of the matching part relative to the position setting and locking system within the positioning mechanism. The number of positions may not be limited to any specific amount and can vary depending, for example, on the size of the electric meter. Thus, there may be at least two different positions, however, preferably more than two, such as at least three, four, or five, and so on, for the matching part.

The mounting component opening in the mounting component is preferably for attachment members of the electric meter. Thus, an opening is devoid of material for an attachment member to be placed on or through it. An attachment member may be an external attachment member, such as a screw, a bolt, or a pin, or the like.

A longitudinal direction of the position setting and locking system of the positioning mechanism within the electric meter may extend in a first direction, such as relative to a portion of the position setting and locking system providing the position adjustment, and the mounting component may extend in a second direction, wherein the first direction is perpendicular relative to the second direction. These directions do not in any way limit or determine other direction(s) of the electric meter or its components or in which other direction(s) the electric meter or its component extend.

The position of the cable connector part of the electric meter may be adjustable or stationary relative to the rest of the electric meter. If it is adjustable, there may be a sliding connection, for example, between the cable connector part and the rest of the electric meter. An adjustable cable connector part may provide added position adjustment capabilities but may not be necessary if, for example, the integrated position adjustment system within the electric meter provides vast enough adjustment capabilities on its own.

In some examples, an adjusting range of the integrated position adjustment system in the direction of the position adjustment may be more than 3 cm, but less than 20 cm. Optionally, the adjusting range may be from 5 to 15 cm, or from 7 to 13 cm, or about 10 cm. The adjusting range may be defined between two extreme positions of the integrated position adjustment system.

According to a second aspect, a combination of the electric meter in accordance with the first aspect and an electric meter mounting plate is provided. The electric meter mounting plate comprises at least one first longitudinal opening extending in a first direction of the electric meter mounting plate, and at least one cable opening for extending at least one cable through the cable opening to be connected to a cable connector part of the electric meter.

The electric meter mounting plate may further comprise at least one second longitudinal opening extending in a second direction of the electric meter mounting plate. The first direction of the electric meter mounting plate and a second direction of the electric meter mounting plate may be perpendicular relative to each other.

According to a third aspect, a method for mounting the electric meter in accordance with the first aspect onto an electric meter mounting plate is provided. The electric meter mounting plate may be as described in the second aspect.

The method comprises: setting and mounting the mounting component onto the at least one first longitudinal opening, such as by attachment member, the at least one first longitudinal opening being parallel to the longitudinal direction of the mounting component. The method also comprises setting the positioning mechanism within the electric meter onto the compatible matching part of the mounting component in a desired position. The order of these steps may be as stated or vice versa.

The method may also comprise mounting the electric meter onto one of the openings that is parallel to the longitudinal direction of the positioning mechanism within the electric meter.

The advantage of the present invention is that the meter position can be adjusted so that the cable connector can be brought closer to the cable end or cable ends. Therefore, the shortening of cables is not so problematic since the electric meter and/or the cable connector part thereof can easily be brought closer to the cables due to the integrated position adjustment system.

### Brief description of the drawings

Some embodiments of the invention are illustrated by way of example, and not by way of limitation, in the figures of the accompanying drawings.
Figure 1 illustrates schematically an electric meter that is mounted on a electric meter mounting plate.
Figure 2 illustrates schematically some components and assembly of the integrated position adjustment system of an electric meter.
Figure 3 illustrates schematically the electric meter in two possible positions in relation to a mounting component of the electric meter.
Figure 4 shows a flow diagram of a method.

### Detailed description

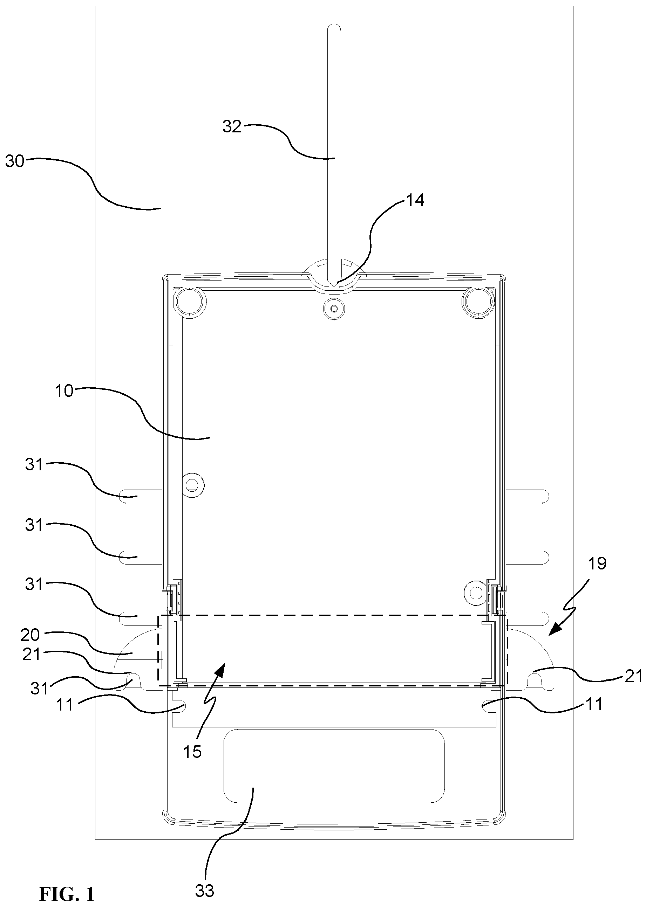

Figure 1 illustrates an embodiment of an electric meter 10, in which the electric meter 10 is mounted onto an electric meter mounting plate 30. The electric meter 10 comprises an integrated position adjustment system 19 for adjusting a position of the electric meter 10 or at least a cable connector part 15 of the electric meter 10. The integrated position adjustment system 19 comprises a positioning mechanism with a position setting and locking system within the electric meter 10. The integrated position adjustment system 19 also comprises a mounting component 20 comprising a compatible matching part to the position setting and locking system of the positioning mechanism, and at least one, preferably two or at least two, mounting component opening(s) 21. Furthermore, the mounting component 20 is arranged to be moved relative to the positioning mechanism when adjusting the position. There may also or may not be attachment points 11 that are fixed or stationary relative to the rest of the electric meter 10.

In Fig. 1, the mounting component 20 may extend behind a body or the rest of the electric meter 10 from one side to another. Thus, the mounting component 20 may extend between the body or the rest of the electric meter 10, and the electric meter mounting plate 30.

The electric meter mounting plate 30 may comprise a plurality of longitudinal openings, of which at least one first longitudinal opening 31 extends in a first direction and, optionally, at least one second longitudinal opening 32 extends in a second direction in a way that the first direction and the second direction are perpendicular relative to each other. An electric meter mounting plate 30 also comprises at least one cable opening 33, through which the cable(s) to be connected to the cable connector part 15 of the electric meter 10 can be arranged through. The cable(s) may, for example, come out of a wall or the like structure behind the electric meter mounting plate 30, that is, from the opposite side of the mounting plate 30 relative to the side to which the electric meter 10 is mounted or is to be mounted.

The electric meter mounting plate 30 may be of or comprise, for example, metal material, however it could be of other substantially rigid material. In some cases, the electric meter mounting plate 30 is made of steel or aluminium.

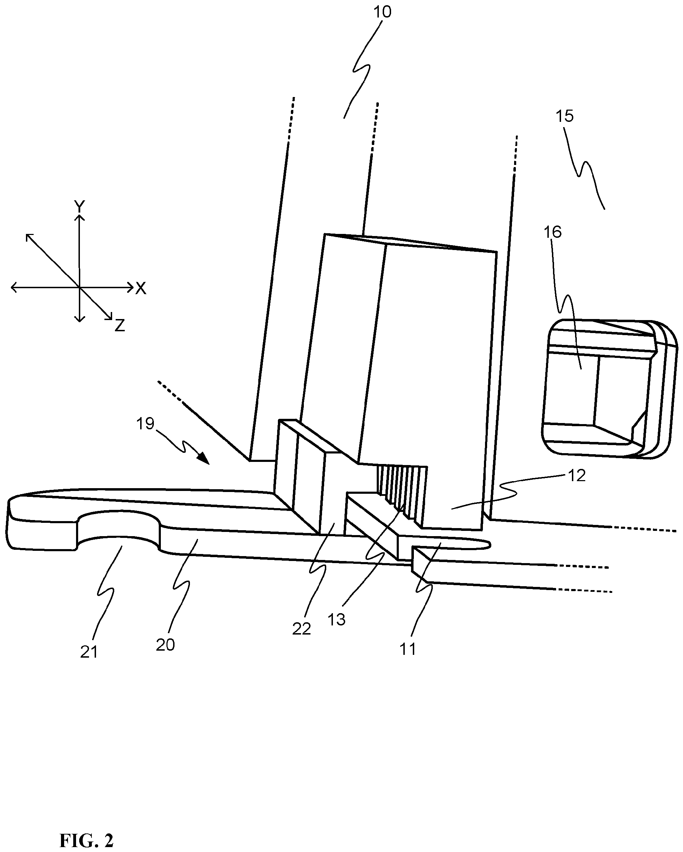

Regarding the electric meter 10, the cable connector part 15 may comprise of at least one cable slot or connector on which the cable(s) can be connected to (shown in Fig. 2).

The position of the cable connector part 15 may be adjustable or stationary relative to the rest of the electric meter 10. If it is adjustable, there may be a sliding connection, for example, between the cable connector part 15 and the rest of the electric meter 10.

As illustrated in Fig. 1, a mounting component 20, which is movable relative to (at least part of) the rest of the electric meter 10, is used to mount the electric meter 10 onto the electric meter mounting plate 30 so that at least one mounting component opening 21 lines up with a first longitudinal opening 31. After the electric meter 10 is mounted on the electric meter mounting plate 30 at a desired position, the electric cables can be connected to the cable connector part 15 of the electric meter 10 after they are arranged to run through the cable opening 33. As can be understood, the electric meter 10, and especially the cable connector part 15 thereof, can be moved closer to the cable or cables, or end(s) thereof, due to the integrated position adjustment system 19. In known electric meters, on the contrary, the electric meter would have to be installed or attached to the mounting plate by attachment points that are fixed or stationary relative to the rest of the electric meter. Embodiments of the present invention may or may not include such fixed attachment points 11. The shortening of the cables, thus, makes the connecting of cables to known electric meters difficult or at least inconvenient.

Figure 2 illustrates schematically some components and assembly of an integrated position adjustment system 19 of an electric meter 10. The electric meter 10 may be as shown in and described in connection to Fig. 1. The electric meter 10 comprises a cable connector part 15 with, preferably, at least one cable slot or connector 16 on which a cable can be connected to, and a positioning mechanism 12 for convenient and comprehensive position setting of the electric meter 10. By design, the positioning mechanism 12 can be, for example, grooved and either stepped or stepless. The longitudinal direction of the groove may, preferably, be parallel with the direction of the position adjustment. The at least one cable slot or connector 16 may comprise a screw terminal or a splice terminal or other type of tightening device.

An example of a stepped design of the position setting and locking system 13 within the positioning mechanism 12 is illustrated in Fig. 2. The length of the position adjustment system 12 within the electric meter 10 in any direction is not limited and can vary depending on the size of the electric meter 10 and the desired or required adjustment capacity of the electric meter 10.

An adjusting range of the integrated position adjustment system in the direction of the position adjustment may be more than 3 cm, but less than 20 cm. Optionally, the adjusting range may be from 5 to 15 cm, or from 7 to 13 cm, or about 10 cm. The adjusting range may be defined between two extreme positions of the integrated position adjustment system.

The integrated positioning system 19 within the electric meter 10 also includes a mounting component 20. The mounting component 20 includes a compatible matching part 22 which is set on the desired position on the position setting and locking system 13 of the positioning mechanism 12. The position setting and locking system 13 may comprise at least two different positions, however, preferably more than two, such as at least three, four, or five, and so on, for the matching part 22.

The means of setting the matching part 22 on the position setting and locking system 13 of the positioning mechanism 12 is dependent on the design of the positioning setting and locking system 13. In a stepped design of the position setting and locking system 13, the matching part 22 can be set on a desired step or steps. The step or steps may provide locking at least in the direction of the position adjustment. In addition, the step or steps alone or together with the rest of the positioning mechanism 12 may prevent movement of the matching part 22 also in at least one perpendicular direction. Thus, there may be at least two different positions, however, preferably more than two, such as at least three, four, or five, and so on, for the matching part 22.

The matching part 22 may be adapted so that it presses against the positioning setting and locking system 13, thus keeping the mounting component 20 in the selected/desired position. In Fig. 2, the matching part 22 may be adapted so that it applies force towards the positioning setting and locking system 13 in the second direction X, being perpendicular relative to the first direction Z and the third direction Y. In Fig. 2, the first direction Z is parallel relative to the direction of the position adjustment. Furthermore, the matching part 22 and the position setting and locking system 13 may be mutually adapted so that, once the matching part 22 is arranged in contact with the position setting and locking system 13, movement of them relative to each other is limited, such as at least in the third direction Y.

In some examples, the matching part 22 may be fastened onto the position setting and locking system 13 as such (by said force and/or mutual adaptation/structure, for instance, by a mechanical interlocking due to corresponding shapes). In a stepless design of the position setting and locking system 13, the matching part 22 can be set on a desired position of the stepless position setting and locking system 13 and the matching part 22 can be fastened onto the position setting and locking system 13 with an external fastening member. An external fastening member may also be used in a stepped design of the position setting and locking system 13.

The mounting component 20 may include one or a plurality of mounting openings 21, which are used for mounting the electric meter 10 onto an electric meter mounting plate 30 with the use of external attachment members, such as screws or bolts or pins. Attaching the electric meter 10 with the use of the at least one mounting component opening 21 on the mounting component 20 replaces the conventional method of using the integrated mounting members 11 within the electric meter 10. Consequently, the position of the electric meter 10 may be adjustable, as the mounting component 20 includes the matching part 22 which can be paired with the position setting and locking system 13 at a desired position.

In Figure 2, three, preferably perpendicular or orthogonal, axes (X-axis, Y-axis, Z-axis), are also illustrated. Upon mounting the electric meter 10, once the matching part 22 and the position setting and locking system 13 are fastened or at least arranged in contact with each other, the mounted electric meter 10 is secured in at least one but preferably three of the possible directions of the axes presented (X-axis, Y-axis, Z-axis).

As understood, the electric meter 10 may further comprise means for performing electric metering. For example, it may comprise voltage and/or current sensors. Furthermore, there may be processing unit(s) and memory devices in the electric meter 10. Still further, the electric meter 10 may comprise a communication unit for providing remote communication capabilities. Still further, the electric meter 10 may comprise a display and/or a user interface, an a power supply, or at least a connector to a power supply.

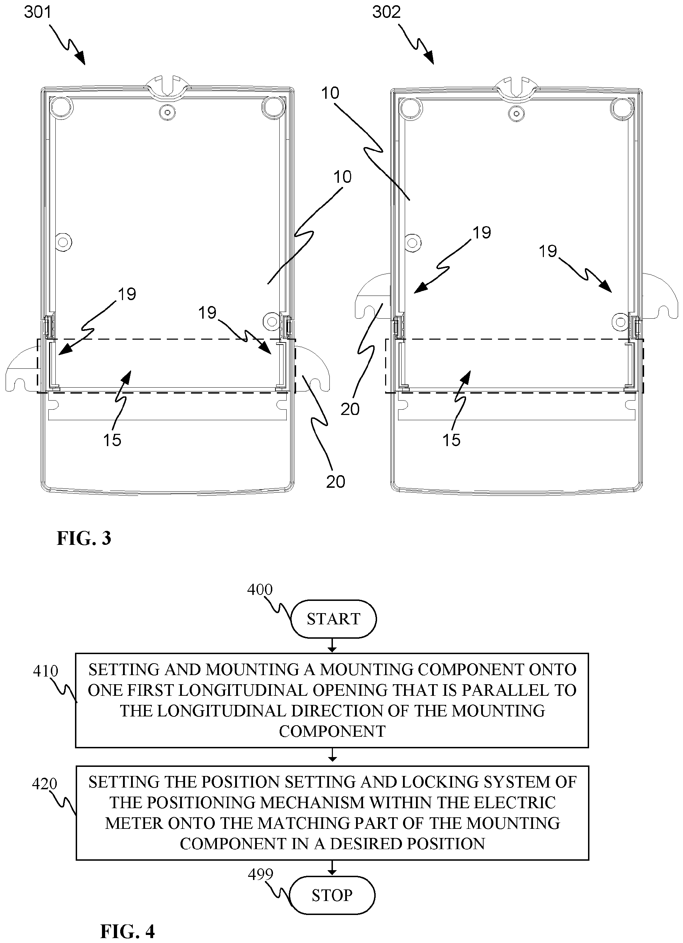

Figure 3 illustrates an electric meter 10 in two example positions 301, 302, where in each of the positions, the position of the mounting component 20 relative to the electric meter 10 and the cable connector part 15 within the electric meter 10 is different. This is made possible by the position adjustment capability of the integrated positioning system 19. In certain scenarios, the initial position of the mounting component 20 relative to the electric meter 10 and the cable connector part 15 within the electric meter 10 can be thought to be the one illustrated in position 301. Following that, position 302 can be thought to be a latter position of the mounting component 20 relative to the electric meter 10 and the cable connector part 15 within the electric meter 10, when the need for a new position is required, which can be, for example, due to the shortening of the electrical cables during their lifetime, which may result in a need to reposition cable connector part 15 within the electric meter 10 in such a way that the shorter cables are closer to the cable connector part 15 within the electric meter 10 and reconnectable to the cable connector part 15 within the electric meter 10. As can be seen, a distance between the mounting component 20 and the cable connector part 15 is different between the position 301, 302. Namely, the distance is bigger in the second position 302 than in the first position 301.

Figure 4 shows a flow diagram of a method. The method is, preferably, for mounting the electric meter onto the electric meter mounting plate 30. Item 400 refers to optional start-up phase of the method. In 400, the electric meter 10 and/or the electric meter mounting plate 30 may be obtained. Furthermore, the electric meter mounting plate 30 may be installed or attached to its position on the wall or other structure. The electric meter 10 may, preferably, be in accordance with an embodiment as disclosed hereinabove or substantially similar. Furthermore, the electric meter mounting plate 30 may also, preferably, be as disclosed hereinabove or substantially similar.

Item or method step 410 refers to setting and mounting the mounting component 20 onto one first longitudinal opening 31, such as by an attachment member, that is parallel to the longitudinal direction of the mounting component 20.

Item or method step 420 refers to setting the position setting and locking system 13 of the positioning mechanism 12 within the electric meter 10 onto the matching part 22 of the mounting component 20 in a desired position.

The order of steps 410 and 420 may be as mentioned or vice versa.

The method may be stopped at 499, however, not necessarily.

In some embodiments, the method may further comprise mounting the electric meter 10 onto a second longitudinal opening 32 that is parallel to the longitudinal direction of the positioning mechanism 12 within the electric meter 10.

## Claims

1. An electric meter (10), comprising;
an integrated position adjustment system (19) for adjusting a position of the electric meter (10) or at least a cable connector part (15) of the electric meter (10), the integrated position adjustment system (19) comprising:
a positioning mechanism (12) with a position setting and locking system (13) within the electric meter (10); and
a mounting component (20) comprising a compatible matching part (22) to the position setting and locking system (13) of the positioning mechanism (12), and at least one mounting component opening (21);
wherein the mounting component (20) is arranged to be moved relative to the positioning mechanism (12) when adjusting the position.

2. The electric meter (10) of claim 1, wherein the positioning mechanism (12) within the electric meter (10) is grooved.

3. The electric meter (10) of claim 1 and 2, wherein the position setting and locking system (13) of the positioning mechanism (12) within the electric meter (10) is stepped or stepless.

4. The electric meter (10) of claim 3, wherein the stepped position setting and locking system (13) of the positioning mechanism (12) within the electric meter (10) includes a plurality of steps for setting the position of the matching part (22) relative to the position setting and locking system (13) within the positioning mechanism (12).

5. The electric meter (10) of any preceding claim, wherein the mounting component opening (21) in the mounting component (22) is for attachment members of the electric meter (10).

6. The electric meter (10) of any preceding claim, wherein a longitudinal direction of the position setting and locking system (13) of the positioning mechanism (12) within the electric meter (10) extends in a first direction (Z) and the mounting component (20) extends in a second direction (X), wherein the first direction (Z) is perpendicular relative to the second direction (X).

7. The electric meter (10) of any preceding claim, wherein the position of the cable connector part (15) of the electric meter (10) is adjustable or stationary relative to the rest of the electric meter (10).

8. The electric meter (10) of any preceding claim, wherein the adjusting range of the integrated position adjustment system (19) is more than 3 cm, but less than 20 cm.

9. A combination of the electric meter (10) of any of claims 1-8, and an electric meter mounting plate (30), the electric meter mounting plate (30) comprising:
at least one first longitudinal opening (31) extending in a first direction of the electric meter mounting plate (30); and
at least one cable opening (33) for extending at least one cable through the cable opening (33) to be connected to a cable connector part (15) of the electric meter (10).

10. The combination of claim 9, wherein the electric meter mounting plate (30) comprises at least one second longitudinal opening (32) extending in a second direction of the electric meter mounting plate (30),
wherein the first direction of the electric meter mounting plate (30) and the second direction of the electric meter mounting plate (30) are perpendicular relative to each other.

11. A method for mounting the electric meter (10) of any of claims 1-8 onto an electric meter mounting plate (30), the electric meter mounting plate (30) comprising:
at least one first longitudinal opening (31) extending in a first direction;
at least one second longitudinal opening (32) extending in a second direction; and
at least one cable opening (33) for extending at least one cable through the cable opening (33) to be connected to a cable connector part (15)
of the electric meter;
wherein the first direction of the electric meter mounting plate (30) and the second direction of the electric meter mounting plate (30) are perpendicular relative to each other;
wherein the method comprises:
setting and mounting the mounting component (20) onto the at least one first longitudinal opening (31) that is parallel to the longitudinal direction of the mounting component (20); and
setting the position setting and locking system (13) of the positioning mechanism (12) within the electric meter (10) onto the matching part (22) of the mounting component (20) in a desired position.

12. The method of claim 11, comprising mounting the electric meter (10) onto a second longitudinal opening (32) that is parallel to the longitudinal direction of the positioning mechanism (12) within the electric meter (10).
